# EUROPEAN PATENT APPLICATION

(11) **EP 2 426 731 A2**
(43) Date of publication of application: **07.03.2012**
(21) Application number: 10820855.4
(22) Date of filing: 30.09.2010
(51) Int. Cl.: H01L 31/042

(54) **SOLAR POWER GENERATION APPARATUS AND MANUFACTURING METHOD THEREOF**

(30) Priority: 30.09.2009 KR 20090093634
(71) Applicant: LG Innotek Co., Ltd., Seoul 100-714 (KR)
(72) Inventor: CHOI, Chul Hwan, Seoul 100-714 (KR)
(74) Representative: Bethenod, Marc
(86) International application number: PCT/KR2010/006709
(87) International publication number: WO 2011/040782

(57) **Abstract**

Provided are a solar cell apparatus and a method of manufacturing the same. The solar cell apparatus includes: a substrate; a back electrode layer on the substrate; an alloy layer on the back electrode layer; a light absorbing layer on the alloy layer; and a front electrode layer on the light absorbing layer.

## Description

### [Technical Field]

The present disclosure relates to a solar cell apparatus and a method of manufacturing the same.

### [Background Art]

As the demands for energy are increased recently, the developments for a solar battery converting solar energy into electric energy are in progress.

Especially, a (Cu(In,Ga)Se₂ (CIGS) based solar battery is widely used, which is a pn hetero junction device with a substrate structure including a glass substrate, a metal back electrode layer, a p-type CIGS based light absorbing layer, a high resistance buffer layer, and an n-type window layer.

Such a solar battery includes a plurality of cells connected to each other and studies for improving the electrical property of each cell are in progress.

### [Disclosure]

### [Technical Problem]

Embodiments provide a solar cell apparatus having improved electrical property such as contact property and improved photoelectric conversion efficiency and a method of manufacturing the same.

### [Technical Solution]

In one embodiment, a solar cell apparatus includes:
a substrate;
a back electrode layer on the substrate;
an alloy layer on the back electrode layer;
a light absorbing layer on the alloy layer; and
a front electrode layer on the light absorbing layer.

In another embodiment, a method of manufacturing a solar cell apparatus includes:
forming a back electrode layer on a substrate;
forming an alloy layer on the back electrode layer;
forming a light absorbing layer on the alloy layer; and
forming a front electrode layer on the light absorbing layer.

In further another embodiment,a solar cell apparatus includes:
a substrate;
a back electrode layer on the substrate;
a light absorbing layer on the back electrode layer;
a front electrode layer on the light absorbing layer;
a connection line extending from the front electrode layer, penetrating the light absorbing layer, and contacting the back electrode layer; and
an alloy layer between the back electrode layer and the connection line.

### [Advantageous Effects]

In relation to a solar cell apparatus according to an embodiment, an alloy layer is formed on the surface of a back electrode layer used as the back contact of a light absorbing layer. Especially, the alloy layer may include an alloy of a first metal in the back electrode layer and a second metal of the light absorbing layer.

At this point, a connection line contacts the back electrode layer through the alloy layer, and the alloy layer may lower a contact resistance between the connection line and the back electrode layer.

In general, when a CIGS light absorbing layer is formed, a MoSe₂ layer may be formed by a reaction a Mo thin film (i.e., a back electrode) and Se. Such a MoSe₂ layer may increase a contact resistance between the back electrode layer and the connection line.

In this embodiment, the forming of the MoSe₂ layer may be suppressed by the alloy layer, thereby preventing the increase of a contact resistance between the back electrode layer and the connection line.

Accordingly, the solar cell apparatus may have improved electrical property and photoelectric conversion efficiency.

Additionally, the surface of the back electrode layer may not be damaged by the alloy layer.

### [Description of Drawings]

Fig. 1 is a plan view of a solar battery panel according to an embodiment.
Fig. 2 is a sectional view taken along the line A-A' of Fig. 1.
Figs. 3 to 9 are views illustrating manufacturing processes of a solar cell apparatus according to an embodiment.

### [Best Mode]

In the description of embodiments, it will be understood that when a substrate, layer, film, or electrode is referred to as being 'on' or 'under' another substrate, layer, film, or electrode, the terminology of 'on' and 'under' includes both the meanings of 'directly' and 'indirectly'. Further, the reference about 'on' and 'under' each component will be made on the basis of drawings. In addition, the sizes of elements and the relative sizes between elements may be exaggerated for further understanding of the present disclosure.

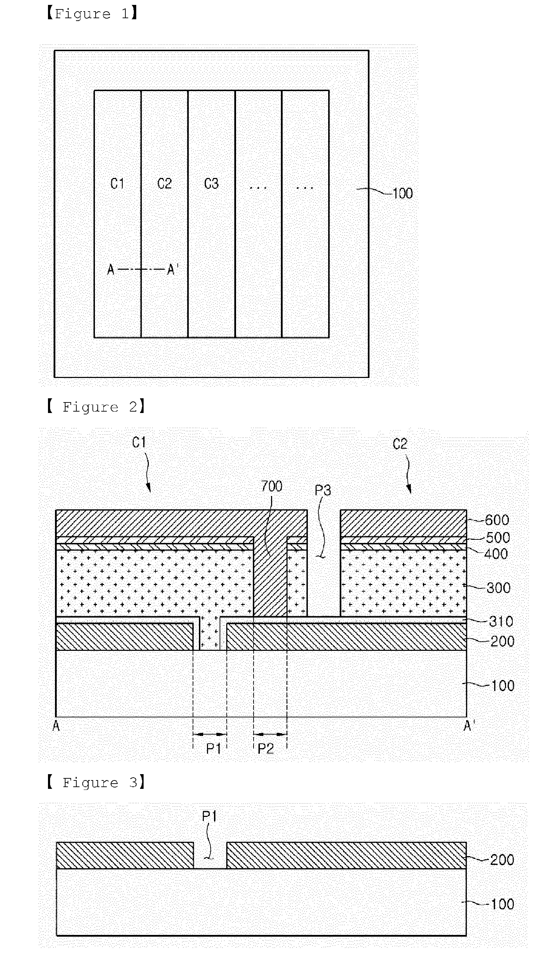

Fig. 1 is a plan view of a solar battery panel according to an embodiment. Fig. 2 is a sectional view taken along the line A-A' of Fig. 1.

Referring to Figs. 1 and 2, the solar battery panel includes a support substrate 100, a back electrode layer 200, an alloy layer 310, a light absorbing layer 300, a buffer layer 400, a high resistance layer 500, a front electrode layer 600, and a plurality of connection lines 700.

The support substrate 100 has a plate shape and supports the back electrode layer 200, the alloy layer 310, the light absorbing layer 300, the buffer layer 400, the high resistance buffer layer 500, the front electrode layer 600, and the connection lines 700.

The support substrate 100 may be an insulator. The support substrate 100 may be a glass substrate, a plastic substrate, or a metallic substrate. In more detail, the support substrate 100 may be a soda lime glass substrate. The support substrate 100 may be transparent. The support substrate 100 may be rigid or flexible.

The back electrode layer 200 is disposed on the support substrate 100. The back electrode layer 200 is a conductive layer. A material used for the back electrode layer 200 may include metal such as molybdenum.

Additionally, the back electrode layer 200 may include at least two layers. At this point, each layer may be formed of the same metal or respectively different metals.

First through holes P1 are formed in the back electrode layer 200. The first through holes P1 are open areas exposing the top side of the support substrate 100. When the first through holes P1 are seen from the top, they may have a shape extending in one direction.

Each of the first through holes P1 may have a width of about 80 µm to about 200 µm.

The back electrode layer 200 is divided into a plurality of back electrodes by the first through holes P1. That is, the plurality of back electrodes are defined by the first through holes P1.

The back electrodes are spaced from each other by the first through holes P1. The back electrodes are disposed in a stripe shape.

Unlike this, the back electrodes may be disposed in a matrix shape. At this point, when the first through holes P1 are seen from the top, they may have a lattice shape.

The alloy layer 310 is disposed on the back electrode layer 200. Additionally, the alloy layer 310 covers the inner lateral side of the first thorough holes P1. At this point, the alloy layer 310 is not formed on the top side of the support substrate 100 exposed through the first thorough holes P1.

The alloy layer 310 includes an alloy. In more detail, the alloy layer 310 includes at least one alloy of a first metal in the back electrode layer 200 and second metals in the light absorbing layer 300.

The alloy layer 310 may include an intermetallic compound. In more detail, the alloy layer 310 may include at least one intermetallic compound of the first metal and the second metals.

The first metal may be Mo. Additionally, the second metals may be selected from Group I elements and Group III elements. In more detail, the second metals may be Cu, Ga, and In.

Accordingly, the alloy layer 310 may include a Mo compound. In more detail, the alloy layer 310 may include a Mo intermetallic compound. In more detail, the alloy layer 310 may include a Mo-Group I element based intermetallic compound, a Mo-Group III element based intermetallic compound, or a Mo-Group I-Group III element based intermetallic compound. In more detail, the alloy layer 310 may include one of MoIn, MoGa, MoCu, Mo(In,Ga), Mo(Ga,Cu), and Mo(In,Ga, Cu).

The alloy layer 310 is interposed between the back electrode layer 200 and the light absorbing layer 300. The alloy layer 310 directly contacts the back electrode layer 200 and the light absorbing layer 300. Additionally, the alloy layer 310 is interposed between the back electrode layer 200 and the connection lines 700. The alloy layer 310 directly contacts the back electrode layer 200 and the connection lines 700.

The alloy layer 310 has a thickness of about 10 nm to about 50 nm. The alloy layer 310 may be formed on an entire surface of the back electrode layer 200.

The light absorbing layer 300 is disposed on the alloy layer 310. The light absorbing layer 300 may directly contact the alloy layer 310. Additionally, the first through holes P1 are filled with a material of the light absorbing layer 300.

The light absorbing layer 300 includes a Group I element, a Group III element, and a VI element. In more detail, the light absorbing layer 300 includes a Group I-III-VI based compound. For example, the light absorbing layer 300 may have a Cu(In,Ga)Se₂ based (CIGS based) crystal structure, or a Cu-In-Se based (CIS based) or Cu-Ga-Se based (CGS based) crystal structure.

The light absorbing layer 300 may have an energy band gap of about 1 eV to about 1.8 eV.

Additionally, the light absorbing layer 300 defines a plurality of light absorbing parts by the second through holes P2. That is, the light absorbing layer 300 is divided into the plurality of light absorbing parts by the second through holes P2.

The buffer layer 400 is disposed on the light absorbing layer 300. The buffer layer 400 includes CdS and has an energy band gap of about 2.2 eV to about 2.4 eV.

The high resistance layer 500 is disposed on the buffer layer 400. The high resistance buffer layer 500 includes i-ZnO undoped with an impurity. The high resistance buffer layer 500 has an energy band gap of about 3.1 eV to about 3.3 eV.

Second through holes P2 are formed in the light absorbing layer 300, the buffer layer 400, and the high resistance buffer layer 500. The second through holes P2 penetrate the light absorbing layer 300. Additionally, the second through holes P2 are open areas exposing the top side of the alloy layer 310.

The second through holes P2 are formed adjacent to the first through holes P1. That is, when some of the second through holes P2 are seen from the top, they are formed next to the first through holes P1.

Each of the second through holes P2 may have a width of about 80 µm to about 200 µm.

The front electrode layer 600 is disposed on the high resistance buffer layer 500. The front electrode layer 600 is a transparent and conductive layer.

The front electrode layer 600 includes an oxide. For example, the front electrode layer 600 may include Al doped zinc oxide (AZO) or Ga doped zinc oxide (GZO).

Additionally, the front electrode layer 600 is divided into a plurality of windows by the third through holes P3. That is, the windows are defined by the third through holes P3.

The windows have a corresponding shape to the back electrodes. That is, the windows are disposed in a stripe shape. Unlike this, the windows may be disposed in a matrix shape.

Additionally, a plurality of cells C1, C2, ... are defined by the third through holes P3. In more detail, the plurality of cells C1, C2, ... are defined by the second through holes P2 and the third through holes P3. That is, the solar cell apparatus includes the plurality of cells C1, C2, ... defined by the second through holes P2 and the third through holes P3.

The connection lines 700 are disposed in the second through holes P2. The connection lines 700 extend from the front electrode layer 600 to the bottom and connect to the back electrode layer 200 through the alloy layer 310. That is, the connection lines 700 directly contact the alloy layer 310. For example, the connection line 700 extends from the window of the first cell C1 and contacts the back electrode of the second cell C2.

Accordingly, the connection lines 700 connect respectively adjacent cells. In more detail, the connection lines 700 connect the window and the back electrode in each of the respectively adjacent cells C1, C2....

The connection lines 700 and the front electrode layer 600 are integrally formed. That is, the connection lines 700 are formed of the same material as the front electrode layer 600.

In relation to the solar cell apparatus, since the connection lines 700 connect to the back electrode layer 200 through the alloy layer 310, the alloy layer 310 may lower a contact resistance between the connection lines 700 and the back electrode layer 200.

In general, when the CIGS light absorbing layer 300 is formed, a MoSe₂ layer may be formed due to a reaction of a Mo thin film (i.e., the back electrode) and selenium. This MoSe₂ layer may increase a contact resistance between the back electrode layer 200 and the connection lines 700.

In this embodiment, the alloy layer 310 may suppress the forming of the MoSe₂ layer and accordingly, may prevent the increase of a contact resistance between the back electrode layer 200 and the connection lines 700.

Accordingly, a solar cell apparatus according to an embodiment may improve photoelectric conversion efficiency, with improved electrical property.

Additionally, the alloy layer 310 may prevent the surface of the back electrode layer 200 from being damaged.

Figs. 3 to 9 are views illustrating manufacturing processes of a solar cell apparatus according to an embodiment. Description of this manufacturing method will refer to that of the above-mentioned solar cell apparatus. That is, the description of the above solar cell apparatus may be substantially combined to that of this manufacturing method.

Referring to Fig. 3, a back electrode layer 200 is formed on a support substrate 100. The back electrode layer 200 may be formed of a conductor such as metal.

For example, the back electrode layer 200 may be formed using a Mo target through a sputtering process. This is because Mo has high electrical conductivity, ohmic contact with the light absorbing layer 300, and high temperature stability under Se atmosphere.

A Mo thin film, i.e., the back electrode layer 200, is required to have a low resistivity as an electrode and have excellent adhesiveness to the support substrate 100 in order to prevent a delamination phenomenon due to a difference in thermal expansion coefficient.

Moreover, a material used for the back electrode layer 200 is not limited to the above and may be formed of Mo doped with Na-ions.

Although not shown in the drawings, the back electrode layer 200 may be formed with at least one layer. When the back electrode layer 200 is formed with a plurality of layers, layers constituting the back electrode layer 200 may be formed of respectively different materials.

First through holes P1 are formed in the back electrode layer 200 and then, the back electrode layer 200 may be patterned. The first through holes P1 may selectively expose the top side of the substrate 100. For example, the first through holes P1 may be patterned through a mechanical device or a laser device. Each of the first through holes P1 may have a width of about 80µm±20.

Additionally, the back electrode layer 200 may be disposed in a stripe shape or a matrix shape by the first through holes P1 and may correspond to each cell. However, the back electrode layer 200 is not limited to the above shape and may be formed in various shapes.

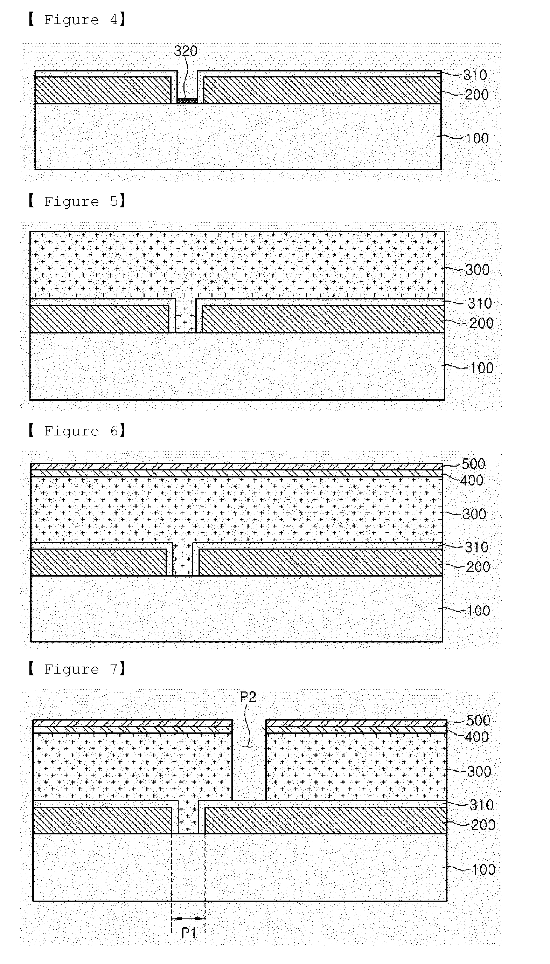

Referring to Fig. 4, an alloy layer 310 is formed on the back electrode layer 200 having the first through holes P1.

In order to form the alloy layer 310, a pretreatment process is performed to form the light absorbing layer 300.

The pretreatment process is a process for depositing Group I and/or Group III elements on the back electrode layer 200 at an atmosphere except Group VI elements through sputtering or co-evaporation. That is, the Group I and/or Group III elements are deposited on the back electrode layer 200 through the sputtering or co-evaporation.

At this point, the pretreatment process may be a high temperature process performed at a temperature of about 500°C to about 1500°C. Accordingly, the alloy layer 310 may be formed by a reaction of the deposited Group I and/or Group III elements and a metal in the back electrode layer 200. That is, the conditions necessary for the pretreatment process may provide a sufficient temperature at which the alloy layer 310 is formed.

An intermetallic compound is prepared by a reaction of the Group I, Group III, or Group I-III elements, which are deposited on the back electrode layer 200, and a metal in the back electrode layer 200 through the pretreatment process.

For example, the pretreatment process is a deposition process using one of Cu, In, Ga, Cu-In, Cu?Ga, In-Ga, and Cu-In-Ga.

Accordingly, the alloy layer 310 formed of one of MoIn, MoGa, MoCu, Mo(Cu,In), Mo(In,Ga), Mo(Ga,Cu), and Mo(In,Ga, Cu) may be disposed on the surface of the back electrode layer 200.

At this point, since the alloy layer 310 is formed due to a reaction to a Mo thin film (that is, the back electrode layer 200), it may not be formed on the bottom side of the through hole P1 exposing the substrate 100.

The alloy layer 310 may be formed with a thickness of about 10 nm to about 50 nm.

After the alloy layer 310 is formed, it may be thermally treated furthermore at a temperature of about 100°C to about 500°C.

The alloy layer 310 may be formed along the surface of the back electrode layer 200. That is, the alloy layer 310 may be selectively formed only on the surface of the back electrode layer 200 and also, a Group I element layer, a Group III element layer, or a Group I-III compound layer 320 may be formed on the bottom side of the first through holes P1.

Referring to Fig. 5, a light absorbing layer 300 is formed on the alloy layer 310.

The light absorbing layer 300 includes a Group I-III-VI based compound.

In more detail, the light absorbing layer 300 includes a Cu(In, Ga)Se2 based (CIGS based) compound.

Unlike this, the light absorbing layer 300 may includes a CuInSe2 based (CIS based) compound or a CuGaSe2 based (CGS based) compound.

The light absorbing layer 300 is formed through a post-treatment process.

The post-treatment process may be performed at an atmosphere including a Group VI element.

The pretreatment process and the post-treatment process may be consecutively performed.

For example, in order to form the light absorbing layer 300, a CIG based metal precursor layer is formed on the back electrode layer 200 including the first through holes P1, by using a Cu target, an In target, and a Ga target.

Later, after a reaction of the metal precursor layer and Se through a selenization process is completed, a CIGS based light absorbing layer is formed.

Additionally, the light absorbing layer 300 may be formed using Cu, In, Ga, and Se through co-evaporation.

Accordingly, the light absorbing layer 300 may be formed on the alloy layer 310.

Especially, the forming of the MoSe₂ layer may be suppressed because the alloy layer 310 prevents a reaction of Se of the light absorbing layer 300 and Mo of the back electrode layer 200.

This MoSe₂ layer may increase a contact resistance between the back electrode layer 200 and a front electrode layer.

Accordingly, this embodiment prevents the forming of the MoSe2 layer by the alloy layer 310 on the back electrode layer 200 and lowers a contact resistance between the back electrode layer 200 and the front electrode layer.

Moreover, a Group I element layer, a Group III element layer, or a Group I-III compound layer 320 may be formed into the light absorbing layer 300 at the bottom side of the first through holes P1 through the post-treatment process.

The light absorbing layer 300 receives external incident light and converts it to electric energy. The light absorbing layer 300 generates photoelectron-motive force through photoelectric effect.

Referring to Fig. 6, a buffer layer 400 and a high resistance buffer layer 500 are formed on the light absorbing layer 300.

The buffer layer 400 is formed of at least one layer on the light absorbing layer 300. The buffer layer 400 may be formed of CdS through chemical bath deposition (CBD).

At this point, the buffer layer 400 is an n-type semiconductor layer and the light absorbing layer 300 is a p-type semiconductor layer. Accordingly, the light absorbing layer 300 and the buffer layer 400 form a pn junction.

The high resistance buffer layer 500 may be formed on the buffer layer 400 as a transparent electrode layer.

For example, the high resistance buffer layer 500 may be formed of one of ITO, ZnO, and i-ZnO.

The high resistance buffer layer 500 may be formed of a ZnO layer through a sputtering process using ZnO as a target.

The buffer layer 400 and the high resistance buffer layer 500 are disposed between the light absorbing layer 300 and a front electrode layer 600 formed later.

That is, since the light absorbing layer 300 and the front electrode layer 600 have a large difference in lattice constant and energy bandgap, the buffer layer 400 and the high resistance buffer layer 500 having an intermediate bandgap of the layers 300 and 600 are inserted therebetween to form an excellent junction.

According to this embodiment, although two buffer layers 400 and 500 are formed on the light absorbing layer 300, the present invention is not limited thereto and thus the buffer layers 400 and 500 may be formed of a single layer.

Referring to Fig. 7, second through holes P2 penetrating the high resistance buffer layer 500, the buffer layer 400, and the light absorbing layer 300 are formed.

The second through holes P2 may expose the alloy layer 310.

The second through holes P2 may be formed adjacent to the first through holes P1.

The second through holes P2 may be formed through a laser irradiation method or a mechanical method using as a tip.

Since the alloy layer 310 is formed on the back electrode layer 200, it protects the back electrode layer 200 from a scribing process for forming the second through holes P2.

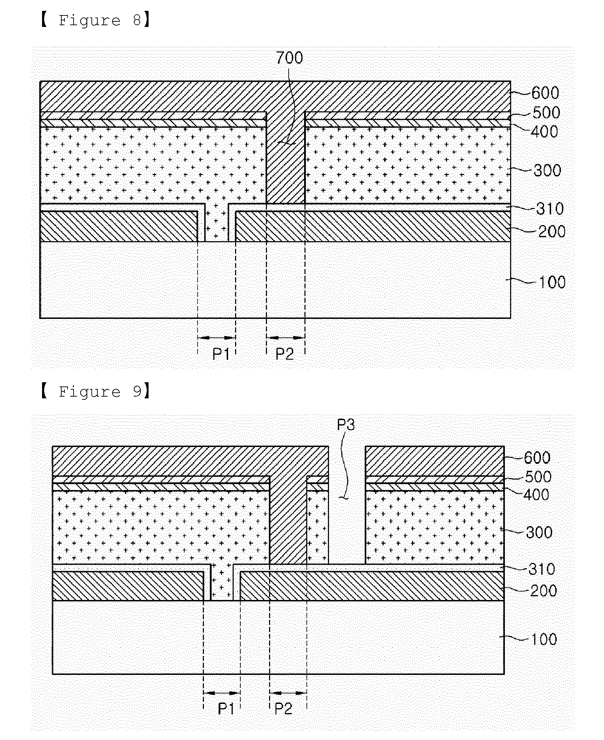

Referring to Fig. 8, a transparent conductive material is stacked on the high resistance buffer layer 500 to form a front electrode layer 600.

When the front electrode layer 600 is formed, the transparent conductive material may be inserted into the second through holes P2 to form connection lines 700.

The connection lines 700 may be electrically connected to the back electrode layer 200 through the second through holes P2.

Especially, the connection lines 700 may contact the alloy layer 310 on the surface of the back electrode layer 200 and thus, may be electrically connected to the back electrode layer 200.

Accordingly, a contact property between the connection lines 700 and the back electrode layer 200 may be improved. Especially, the mobility and conductivity of a current flowing along the surface of the back electrode layer 200, used as a back contact of the solar cell apparatus, may be improved.

The front electrode layer 600 is formed of ZnO doped with Al or Al203 through a sputtering process.

The front electrode layer 600 is a window layer forming a pn junction with the light absorbing layer 300. Since the front electrode layer 600 serves as a transparent electrode at the front side of a solar battery, it is formed of ZnO having high light transmittance and excellent electrical conductivity.

Accordingly, an electrode having low resistance value may be formed by doping the ZnO with Al or alumina.

A ZnO thin film, i.e., the front electrode layer 600, may be formed through an RF sputtering method using a ZnO target, a reactive sputtering method using a Zn target, and a metal organic chemical vapor deposition method.

Additionally, a double structure, in which an ITO thin film having excellent electro-optical property is deposited on a ZnO thin film, may be formed.

Referring to Fig. 9, third through holes P3 penetrating the front electrode layer 600, the high resistance buffer layer 500, the buffer layer 400, and the light absorbing layer 300 are formed.

The third through holes P3 may selectively expose the alloy layer 310. The third through holes P3 may be formed adjacent to the second through holes P2.

The third through holes P3 may be formed through a laser irradiation method or a mechanical method using a tip.

When the third through holes P3 are formed, the alloy layer 310 protects the surface of the back electrode layer 200.

That is, since the alloy layer 310 is formed on the surface of the back electrode layer 200, it serves as a protection layer of the back electrode layer 200 during the etching process using laser or a tip. Accordingly, the back electrode layer 200 may not be damaged.

The light absorbing layer 300, the buffer layer 400, the high resistance buffer layer 500, and the front electrode layer 600 may be mutually separated by each cell through the third through holes P3.

At this point, the connection lines 700 connect each cell. That is, the connection lines 700 may physically and electrically connect the back electrode layer 200 and the front electrode layer 600 in the mutually adjacent cells.

According to this embodiment, the alloy layer 310 may be formed on the back electrode through the pretreatment process of the CIGS light absorbing layer 300.

The alloy layer 310 suppresses the forming of the MoSe2 layer when the light absorbing layer 300 is formed, so that the contact property of the back electrode may be improved.

Accordingly, a solar cell apparatus according to an embodiment may improve electrical property and photoelectric conversion efficiency.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### [Industrial Applicability]

A solar battery panel according to an embodiment may be used for photovoltaic power generation fields.

## Claims

1. A solar cell apparatus includes:
a substrate;
a back electrode layer on the substrate;
an alloy layer on the back electrode layer;
a light absorbing layer on the alloy layer; and
a front electrode layer on the light absorbing layer.

2. The solar cell apparatus according to claim 1, wherein the alloy layer comprises an alloy of a first metal in the back electrode layer and a second metal in the light absorbing layer.

3. The solar cell apparatus according to claim 2, wherein the alloy layer comprises an intermetallic compound of the first metal and the second metal.

4. The solar cell apparatus according to claim 1, wherein the alloy layer comprises a Mo alloy.

5. The solar cell apparatus according to claim 1, further comprising a connection line extending from the front electrode layer and directly contacting the alloy layer.

6. The solar cell apparatus according to claim 1, wherein the alloy layer comprises a Mo-Group I based intermetallic compound, a Mo-Group III based intermetallic compound, or a Mo-Group I-Group III based intermetallic compound.

7. The solar cell apparatus according to claim 1, wherein the alloy layer comprises MoIn, MoGa, MoCu, Mo(In,Ga), Mo(Ga,Cu) or Mo(In,Ga, Cu).

8. The solar cell apparatus according to claim 1, wherein the alloy layer has a thickness of about 10 nm to about 50 nm.

9. The solar cell apparatus according to claim 1, wherein
a plurality of first through holes are formed in the back electrode layer; and
the alloy layer covers inner lateral sides of the first through holes.

10. The solar cell apparatus according to claim 1, wherein the alloy layer directly contacts the back electrode layer and the light absorbing layer.

11. A method of manufacturing a solar cell apparatus, the method comprising:
forming a back electrode layer on a substrate;
forming an alloy layer on the back electrode layer;
forming a light absorbing layer on the alloy layer; and
forming a front electrode layer on the light absorbing layer.

12. The method according to claim 11, wherein the forming of the alloy layer comprises:
depositing a second metal on the back electrode layer; and
forming the alloy layer prepared by a reaction of a first metal in the back electrode layer and the second metal.

13. The method according to claim 12, wherein the second metal is a Group I element or a Group III element.

14. The method according to claim 12, wherein the first metal is Mo and the second metal is Cu, Ga, or In.

15. The method according to claim 11, wherein the forming of the alloy layer comprises:
simultaneously depositing a Group I element and a Group III element on the back electrode layer; and
forming the alloy layer prepared by a reaction of a metal in the back electrode layer and the Group I and III elements.

16. The method according to claim 11, further comprising:
forming a plurality of second through grooves in the light absorbing layer; and
forming a connection line in the second through grooves, the connection line extending from the front electrode layer and directly contacting the alloy layer.

17. A solar cell apparatus comprising:
a substrate;
a back electrode layer on the substrate;
a light absorbing layer on the back electrode layer;
a front electrode layer on the light absorbing layer;
a connection line extending from the front electrode layer, penetrating the light absorbing layer, and contacting the back electrode layer; and
an alloy layer between the back electrode layer and the connection line.

18. The solar cell apparatus according to claim 17, wherein the alloy layer directly contacts the back electrode layer and the connection line.

19. The solar cell apparatus according to claim 1, wherein the alloy layer comprises an alloy of a first metal in the back electrode layer and a second metal in the light absorbing layer.
